# EUROPEAN PATENT APPLICATION

(11) **EP 1 729 347 A2**
(43) Date of publication of application: **06.12.2006**
(21) Application number: 06380115.3
(22) Date of filing: 17.05.2006
(51) Int. Cl.: H01L 31/0352, H01L 31/101

(54) **Quantum dot intermediate band infrared photodetector**

(30) Priority: 30.05.2005 ES 200501296
(71) Applicant: UNIVERSIDAD POLITECNICA DE MADRID, 28040 Madrid (ES); THE UNIVERSITY COURT OF THE UNIVERSITY OF GLASGOW, Glasgow G12 8QQ (GB)
(72) Inventor: Martì, Antonio Instituto de Energia Solar, Madrid (ES); Luque, Antonio Instituto de Energia Solar, Madrid (ES); Stanley, Colin, Glasgow G12 8QQ (GB); Lòpez, Nair Instituto de Energia Solar, Madrid (ES); Cànovas, Enrique Instituto de Energia Solar, Madrid (ES); Antolin, Elisa Institudo de Energia Solar, Madrid (ES)

(57) **Abstract**

The invention relates to an infrared photodetector containing a region of semiconductor quantum dots (1), *n* type doped in the barrier region (2), and sandwiched between two layers of semiconductors of *n* type (3) and *p* type (4). When infrared photons (5) are absorbed, they create electronic transitions (6) from the confined states in the dots (7) to the conduction band (8). This causes the appearance of a voltage between device *p* (9) and n (10) contacts or the production of an electrical current. In either way, the detection of the infrared light is possible. A low band-pass filter (12) prevents high energy photons (13) from entering the device and cause electronic transitions (14) from the valence (15) band to the conduction band (8).

## Description

Infrared photodetectors are traditionally classified into thermal and photon devices. In thermal devices, the detection of radiation is based on the change of temperature that the absorption of infrared (IR) radiation causes in some sensitive component (gas, resistor, thermocouple, piezoelectric material) of the detector. This change modifies some physical property of the component which is the one triggering the detection. Examples of these are the pyroelectric detectors, Golay cell detectors, thermopiles and bolometers.

This patent deals with photon devices characterised by the absorption of IR radiation is related to the transition of electrons from a lower energy state to a higher energy state. Known IR photon photodetectors are based either on the use of low bandgap semiconductor materials, such us HgTe, InSb, InAs, CdHgTe, or the use of low dimensional structures, such as quantum wells or dots.

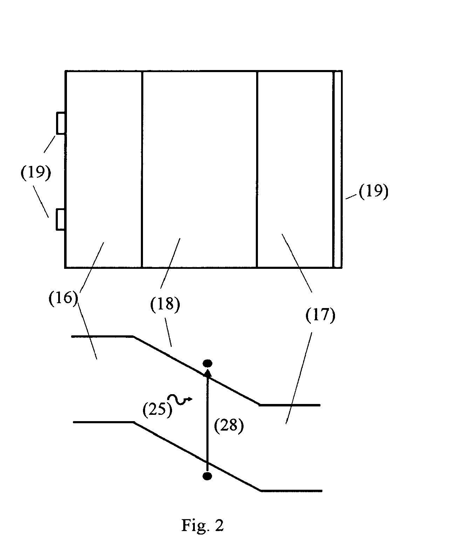

The basic structure of a low bandgap photodetector is pictured in Figure 2. It consists of a *p* (16) and *n* (17) layers sandwiching the low bandgap semiconductor (18), that can be doped or not, plus some metallic contacts (19). The detection of IR radiation is based on the photovoltaic effect. Hence, when a photon with energy above the bandgap is absorbed, it pumps an electron from the valence band to the conduction band in the low bandgap semiconductor (28). IR radiation can be detected well as photocurrent (best when the device is short-circuited) or as photovoltage (best when the device is open-circuited). An IR photodetector based on the use of low bandgap semiconductors materials relies on the natural existence of a semiconductor whose bandgap fits the value of the wavelength of the radiation to be detected.

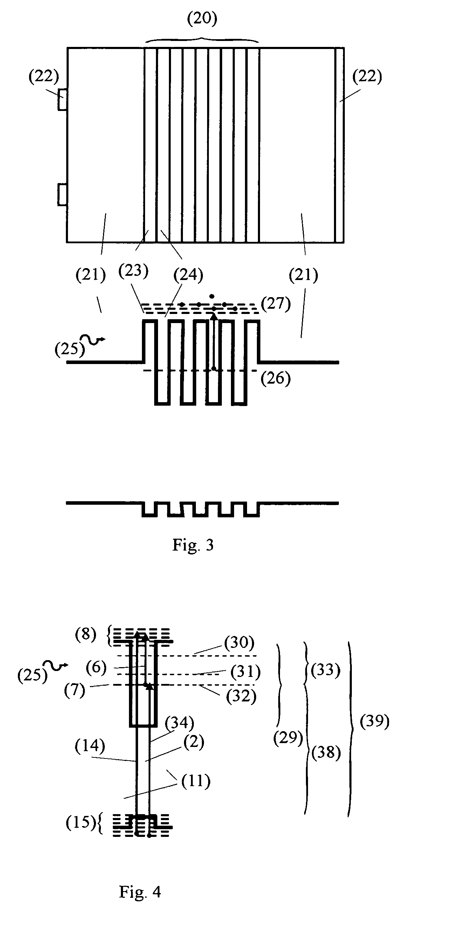

The basic structure of a conventional photodetector based on low dimensional structures is laid out in Figure 3. In this case, a multiple quantum well or even a quantum dot region (20) is sandwiched in-between two semiconductor layers (contacting layers) of the same doping (21), typically of *n* type with metal contacts on them (22). Patents US6452242, US0017176, US0094597 and US6239449 belong to this type of detector based in quantum dots. The detection of light is based on a change in the electron conductivity. They allow also to tune the detection wavelength by changing the physical dimensions of the quantum structure. Hence, when an infrared photon (25) is absorbed (Figure 4), it pumps an electron from the confined states (26) to the conduction band (27). The process is usually called inter sub-band absorption. This increases the number of electrons in the conduction band (27) and, therefore, the electron conductivity what ultimately will allow the detection of the incident IR light. To make the absorption of an IR photon possible, the barrier material (23) is doped in order to fill with electrons the confined states (26). An specific draw-back of using quantum wells is that, due to optical selection rules, the absorption of light at normal incidence is not possible what can be amended by using quantum dots. A general draw-back of these photodetectors is that they do not allow for detection of light in the photovoltaic mode (that is, without, the appliance of a voltage between device terminals). This degrades the detectivity (capability to discriminate signal from noise) of the photodetector and makes necessary the cooling of the device in order to improve it. Nevertheless, detection of light in the photovoltaic mode has been reported although it is considered accidental and the physical reasons for it are not well understood in the literature.

The semiconductor (23) that surrounds the quantum structure (24) ― the wells or the dots ― is called barrier material and has a bandgap higher than the contacting layers (21). Would the contacting layers have a higher bandgap than the barrier material, these regions would be the ones dominating the resistance of the device by blockading the extraction of current instead of the modulation achieved by the IR radiation. The fact that the contacting layers (21) have the same type of doping and a bandgap lower than the barrier material, must be emphasised to distinguish our invention from these devices. As it will become clear soon, our invention, with an structure apparently similar to the one just described is characterised, however, because the sandwiching layers are of different type (p and n) and, for better performance, their bandgap is higher than the one of the barrier material.

When the two types of photodetectors mentioned above are compared each other, the ones based on low bandgap semiconductors have the advantage of operating in the photovoltaic mode what implies they exhibit a better detectivity. However, only a few semiconductors compounds become available. Conversely, the detectors based on low semiconductor structures are not conceived to operate in the photovoltaic mode and, therefore, have a potentially worst detectivity. In return, they offer a wider spectrum for wavelength detection since this can be tuned by changing the dimensions of the quantum structures.

The invention described here combines the best of both type of devices. From one side, it is conceived to operate in the photovoltaic mode. On the other hand, the use of quantum dots allows to tune the wavelength of detection. For these combinations of features being possible, our invention exploits the physical properties predicted in the literature for intermediate band materials. These are characterised by the existence of an intermediate electronic band in-between what otherwise would be a conventional semiconductor bandgap. Intermediate band materials are still mostly a theoretical concept. Some papers, however, have appeared in the literature proposing its synthesis by means of GaₓAsTi₁₋ₓ, II-Oₓ-VI₁₋ₓ highly mismatched alloys and even quantum dots. In some cases, some preliminary experimental results have been provided demonstrating the existence of this intermediate band.

Concerning the use of the quantum dots for infrared radiation detection, our patent differs from other patents, as patents US6452242, US0017176, US0094597 and US6239449 which also use quantum dots to detect IR radiation, in the fact that the so-called "emitters", (3) and (4) have different types of doping in our patent (one is *p*-type and the other one is *n*-type), while in US6239449 the emitters are the same type (both of them are *n*-type or *p*-type). Far from being a minor change, as will be better understood in the description of the invention in the next section, it turns out to be a fundamental modification as far as our invention is concerned, because if the "emitters" had the same doping type our invention would not explode the physical principle of the intermediate band. Hence, in our invention, the carriers pumped by means of infrared light to higher energy levels are substituted by carriers from the valence band, and not by carriers from the "emitter".

Besides of the above (operation under the IB principle), our invention also differs from others, such as US6657195, US6642537, US6531700, US136909, in the fact that the latest use quantum wells for IR radiation detection, while our invention proposes the use of quantum dots. As explained below, quantum wells do not provide the zero density of states between the confined states and the conduction band which is required by our invention.

### DESCRIPTION OF THE INVENTION

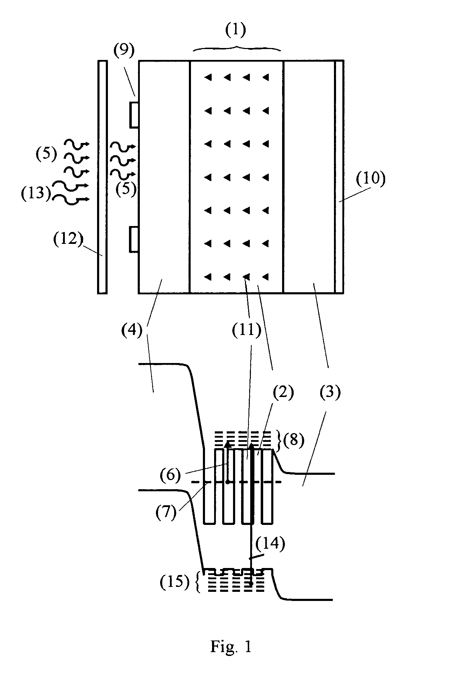

We call our invention "quantum dot intermediate band infrared photodetector" (QDIB-IR). Figure 1 shows its basic structure. It consists of a semiconductor region (1) with quantum dots (11) embed in it and sandwiched by two semiconductor regions, called "emitters". One of these emitters is of *p* type (4) and the other is of n type (3). Metal contacts, (9) and (10), are placed on these emitters. The contact located at the front side (9), that is, the side to receive the IR radiation (5), must not cover completely this area in order to allow radiation to come through. Typically, it should get the form of a grid.

The material that constitutes the dots (11) is called "dot material" and the material that surrounds it, "barrier material" (2). These are made of different semiconductors, characterised usually by different gaps. When properly chosen, they can lead to a simplified band diagram, also in Figure 1, but with some more detail in Figure 4. The band structure plotted is characterised by the appearance of an energy barrier for electrons in the conduction band. The height of this barrier (29) is known as depth of the potential well nevertheless quantum dots, wires or wells are being described. Conceptually, this invention will work also if the confinement potential is created in the valence band. Besides, the example chosen for illustration purposes is known as type I heterostructure, but other heterostructure types, like type II, can also work as far as this invention is concerned. Type II heterostructures are characterised by the conduction band of the dot material falls below the valence band of the barrier material or the conduction band of the barrier material falls below the valence band material. The fact we are specifically talking about "dots" implies that the barrier material completely surrounds the dot material.

The small dimension of the dots, in the range of a few nanometres, causes the quantum confinement of the electrons in the dot. This confinement is characterised because only a few energy levels (7) are allowed for electrons in the range of energies that compromises the potential well (29). If the dot is sufficiently small, it is possible to reach the ideal situation in which only one of these energy levels exist. With intrinsic semiconductor materials being used and in equilibrium conditions, these energy levels will be emptied of electrons. As far as this invention is concerned, it is necessary this energy levels are not emptied of electrons. Hence, the barrier (11) is n doped so that by the physical effect known as modulated doping, the electron is transferred from the impurity to this confined state. Doping density should be in the order of the dot density. A much higher doping could fill states in the conduction band and therefore, degrade photon absorption since empty states in the conduction band are necessary to allocate the electrons pumped from the confined states. Conversely, a lower density can insufficiently fill the confined states and again prevent photon absorption due to the absence of electrons to be pumped to the conduction band. Doping within the dot can produce the same filling of the confined states with electrons. However, effectively doping in the dot is considered technologically more difficult than doping in the barrier. Alternatively, if the structure of the QDIB-IR photodetector would have been based on electron confinement in the valence band instead of confinement in the conduction band, p type doping would be required, in the barrier region or in the dot regions with the same considerations than above, to supply with holes the confined states. This is due to the fact that, in this case, empty states would be required in the confined states to receive the electrons from the valence band pumped by the IR radiation.

When more than one that dot is considered, the collection of confined states in the dot leads to a band, particularly, if the dots are located in a periodic fashion. This band is known in the literature as intermediate band. In order this band is effectively separated from the conduction band, where "effectively" means that a zero density of states exist between both, the use of quantum dots is a must. Our invention requires a zero density of states between the intermediate band and the conduction band. Quantum wells or wires do not provide such zero density of states.

We will refer equivalently in this invention to the collection of confined states also as intermediate band. Conduction, intermediate and valence band have their own quasi-Fermi level to describe the electron population in each of them, to know, conduction band quasi-Fermi level (30), intermediate band quasi-Fermi level (31) and valence band quasi-Fermi level (32). With a high dot density, the quasi-Fermi level related to the intermediate band (31) can remain clamped to its equilibrium position, which is that of the intermediate band, even when the device becomes biased or illuminated.

The wavelength of the IR radiation that will become effectively detected by this detector is that whose energy is in the order of the energy that separates the intermediate band (7) from the conduction band (8). By changing the dimensions of the dots it is possible to change the level of the confined states and therefore, to tune the wavelength to be detected.

When an infrared photon impinges in the detector and is absorbed, it causes an electronic transition (6) from the intermediate band (7) to the conduction band (8), a process usually known as inter-subband transition. To detect this absorption process, and therefore, to detect the incident IR radiation, the detector can be operated both in voltage mode as in current mode.

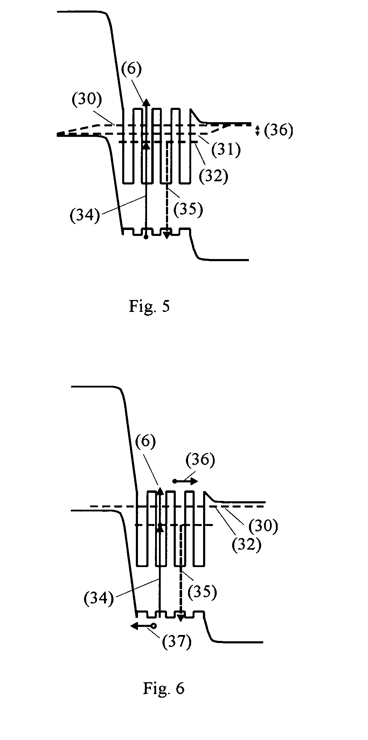

In the voltage mode, the photodetector is open-circuited. Figure 5 shows the simplified bandgap diagram of the device operating under these conditions. The transition of electrons from the intermediate band to the conduction band (8) rises up the quasi-Fermi level of electrons in the conduction band (30). Without the need of external incident radiation above the ambient one, thermal process pump electrons from the valence band to the intermediate band (34). As it is known, in equilibrium, these processes are exactly balanced by the reverse ones or recombination processes (35). But when IR radiation promotes electrons from the intermediate band to the conduction band, equilibrium is broken and the valence band quasi-Fermi level (32) also rises up above the intermediate band quasi-Fermi level (31). The difference in the value between conduction and valence band quasi-Fermi levels becomes the output photovoltage (36) of the device multiplied by the electron charge.

In the current mode, the photodetector is short-circuited (Figure 6). In this case, the absorption of IR photons also causes electronic transitions from the intermediate band to the conduction band (6) and rises up the conduction band quasi-Fermi level (30) as in the case before. Since now the detector is short-circuited, the output voltage is cero and the valence band quasi-Fermi level (32) equals the electron one. The recombination of electrons (35) between the intermediate band and the valence band is reduced and a current is extracted that is limited by the thermal generation (34) between the valence band and the intermediate band. This current is extracted as electrons (36) that exit the n contact and that equal the number of holes per unit of time that exit the p contact (37).

The QDIB-IR detector shares with low bandgap photodetectors its operation in the photovoltage mode, and therefore, a potential for a higher detectivity that can allow their operation at room temperature where other IR detectors require cooling. It shares with the IR detectors based on conductivity change, also making use of low dimensional structures, the fact that its threshold bandgap for IR absorption can be tuned as the dimensions of the dots are changed. Both advantages are now combined in our device that also has the advantage of being capable of detecting light at normal incidence.

To fully exploit the high detectivity potential, a low energy band-pass filter (12) should be located in front of the side receiving the radiation. As it is known, detectivity improves if no current (or voltage) is obtained from the device when it is not illuminated with the radiation to detect. Hence, for best performance regarding detectivity, this filter should blockade the pass of photons with energy higher or equal than the gap that separates the intermediate band from the valence band (38).

However, it is possible to expand the bandwidth of this filter at the price of sacrificing some detectivity in order to get some other advantage. At this respect it was mentioned before, that current in the photodetector was limited by the thermal generation between the valence band and the intermediate band (34). This limit can be increased, on one side, by choosing materials that lead to a low energy gap between the valence band and the intermediate band (38) since this thermal generation depends exponentially on this gap. On the other hand, this limit can also be increased by allowing external illumination to come into the device. This external illumination can be that proceeding accidentally from background ambient light sources (bulbs, sun...) or coming specifically from a dedicated light source like an external light emitting diode (LED) or laser. When background light is the chosen option, it is necessary to increase the bandwidth of the filter in front of the device (12, Figure 1) to allow photons with energy above the gap that separates the valence band from the intermediate band (38) to also reach the device but still blockade photons with energy higher or equal than the gap between the valence band and the conduction band (39). Detectivity is reduced because under these circumstances, even when no IR radiation is present, current would be extracted from the device. This current would have its origin in the external illumination that pumps electrons from the valence band to the intermediate band (34) and the thermal generation that pumps electrons from the intermediate band to the conduction band (6).

Under circumstances in which detectivity is not a concern, the filter (12) could be removed. In this case, when no IR is present, some dark current would be extracted from the device since, in addition to the mechanisms described above, external non infrared illumination could pump electrons directly from the valence band to the conduction band (14).

Hence, as already anticipated, while in other photodetectors using low dimensional structures the emitters are not only of the same type (21) (say n type) but must have a bandgap lower than the barrier material, our invention works better if the emitters have a higher bandgap. A higher bandgap decreases the recombination in the emitters and therefore improves (decreases) the dark current of the device. This translates into a higher gain of the photodetector.

In the current mode, the device could also be operated at a reverse bias. This would be, however, at the cost of sacrificing some detectivity of the device. This is because, again, a reverse saturation current would be extracted from the device even when no IR radiation is present, having its physical origin in the thermal generation processes between bands as, for example, those taking place between the valence band and the conduction band.

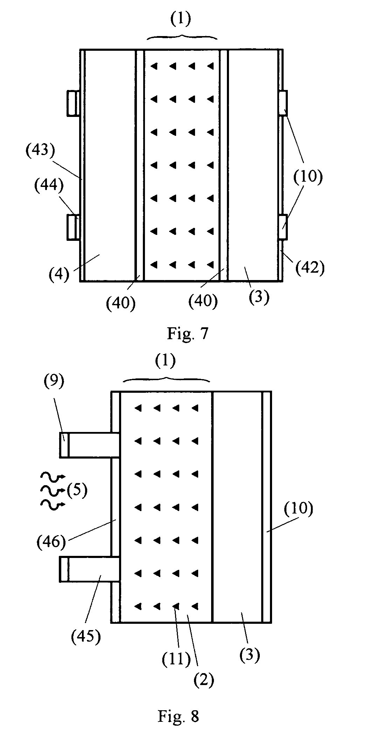

Some other refinements can be applied to the structure of the device (Figure 7). At this respect, due to band bending in the regions close to the emitters, dots close to the p emitter (4) will be emptied of electrons while dots close to the n emitter (3) will be completed filled. From one side, dots emptied of electrons will not serve to the purpose of detecting IR radiation since the required electron to be pumped to the conduction band will not become available. In cases where for technical or practical reasons a limited amount of quantum dots can be grown it is better to devote these dots to absorb IR radiation rather than to sustain the band bending. Instead, a n type layer (40) can be grown close to the p emitter to sustain it. On the other hand, this band bending in the space charge regions also modifies the shape of the confining potential of the dots and therefore the position of the energy levels. This increases the difficulty to engineer the detection wavelength. In either way, conventional p (41) and n (40) semiconductor layers could be inserted adjacent to the emitters to sustain the band bending of the corresponding space charge regions instead of the region with quantum dots (1). We call these layers "damping" layers.

An IR reflector (42) could also be located at the rear side of the device to reflect back to the quantum dot region the photons that have not been absorbed. In this case, the back contact (10) should also take the form of a grid.

Besides, additional and more conventional semiconductor layers devoted to reduce surface recombination (43), such us AlGaAs, for example, in the case GaAs is used for manufacturing the emitters and highly doped regions (44) underneath metal contacts can complete the device structure. These contacting layers, made of a wide bandgap semiconductor would be in theory transparent to IR radiation and therefore, there would be no harm would they cover completely the front side of the emitter rather than being restricted to the regions underneath the metal contacts. In practice, it might not be the case since their high doping might cause free electron absorption processes to turn them into IR absorbers.

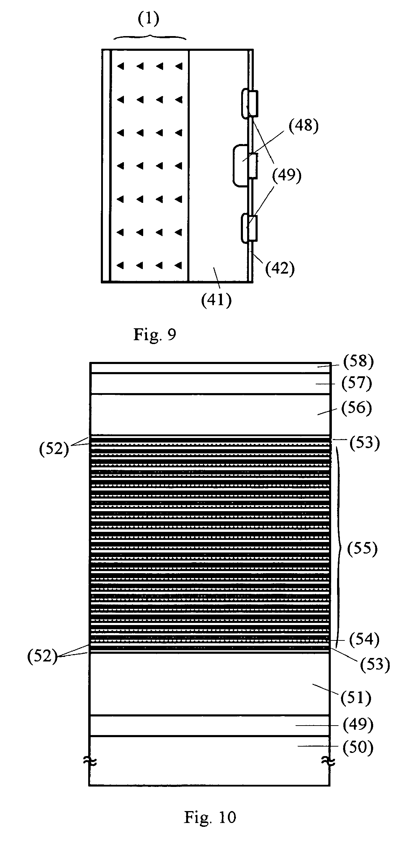

Finally, it must be mentioned, that it is not essential for the operation of the device that the emitters take the form of layers. It is only necessary that at least a p and an *n* region exist. It is possible to take advantage from this fact as shown, for example, in Figure 8 where the p emitter (45) has been reduced to occupy the region underneath the contacts. The surface of the now completely exposed to IR radiation quantum dot region (1) should be passivated (46). This geometry also takes the advantage from the fact that the current extracted from the detector is small so that a some higher series resistance than in other optoelectronic devices, like for example solar cells, can be tolerated, furthermore if the device is operated in the voltage mode. It must be kept in mind, however, that a higher series resistance will worsen the detectivity of the device by increasing the internal noise. The concept can be taken to the limit of locating both the p (47) and n (48) contacts at the rear side of the device (Figure 9). In this way, the shadowing introduced by the front grid would be avoided and the gain increased.

### DETAILS OF PREFERRED EMBODIMENTS

The details of the preferred embodiments will be explained assisted by Figure 10. A 0.1 µm GaAs *n*⁺ type (10¹⁸ cm⁻³, silicon doped) buffer layer (49) is grown in a molecular beam epitaxy (MBE) system over a *n* type (5×10¹⁷ cm⁻³) substrate (50). This layer (49) will also act as back surface field layer to reduce back surface recombination. Successively, the following layers are grown on top:
a) a 0.3 µm thickness layer of *n* type-GaAs, 10¹⁸ cm⁻³, silicon doped (51). This layer forms the *n* emitter (3) described in the invention.
b) a 5 nm thickness layer of undoped GaAs (52).
c) a 4×10¹⁰ cm⁻² delta silicon doped layer (53).
d) 5 nm thickness layer of undoped GaAs (52).
e) 2.7 monoatomic layers of InAs (54). Due to the lattice mismatch between InAs and GaAs, this layer turns into a layer of quantum dots within the process known in the literature as Stranski-Krastanov's. The expected density of dots is 4×10¹⁰ cm⁻².
f) process "b" to "e" is repeated 20 times leading to the layer structure marked as (1) in Figure 9.
g) a 5 nm thickness layer of undoped GaAs (52).
h) a 4×10¹⁰ cm⁻² delta silicon doped layer (53).
i) a 5 nm thickness layer of undoped GaAs (52).
j) a 0.2 µm thickness layer of p type-GaAs, 2×10¹⁸ cm⁻³, Be doped (56). This layer forms the p emitter (4) described in our invention.
k) a 0.1 µm thickness layer of p type-GaAs, 10¹⁹ cm⁻³, Be doped (57). This layer is to favour the metal contacts.
l) a 50 nm thickness layer of p type Al_{0.8}Ga_{0.2}As, 10¹⁹ cm⁻³, Be doped (58). This layer is used to passivate the front emitter.

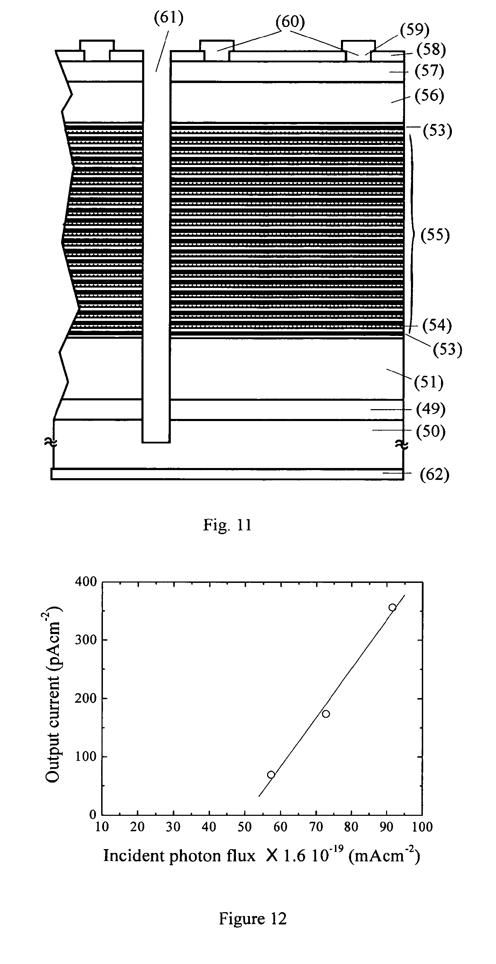

We continue now our description with the help of Figure 11. By using conventional photolithography techniques, the AlGaAs layer is selectively removed from selected places on the surface (59) by controlled chemical etching. On this holes, metal (Ti/Pd/Au) is then deposited by a combination of photolithography and lift-off procedures (60). By using again photolithography, devices are isolated from each other by mesa etching (61). Metal is deposited at the rear side to form the contact on the n side of the device (62).

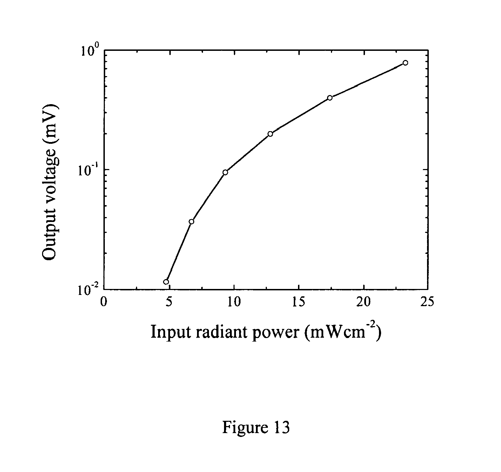

Devices fabricated according to the recipe above have been manufactured and tested as IR photodetectors both in the current as in the voltage mode. For doing so, they were illuminated at normal incidence with a black body source at 850 C filtered by a 400 µm GaSb unintentionally doped wafer that plays the role of the filter (12). This filter blockades radiation below 1700 nm. Devices were operated at room temperature. Results are shown in Figure 12 (current mode) and Figure 13 (voltage mode) and demonstrate the operation of the devices as IR photodetectors.

### EXPLANATION OF THE DRAWINGS

Figure 1. Basic structure of the QDIB-IR photodetector.
Figure 2. Basic structure of a low semiconductor bandgap photodetector. The plot below shows the simplified band structure.
Figure 3. Basic structure of a photodetector based on low dimensional structures and electron conductivity change. The plot below shows the simplified band structure.
Figure 4. Detail of the simplified bandgap diagram in the neighbourhood of a quantum dot.
Figure 5. Simplified bandgap diagram of a QDIB-IR photodetector operated in open-circuit conditions (votage mode).
Figure 6. Simplifies bandgap diagram of a QDIB-IR photodetector operated in short circuit conditions (current mode).
Figure 7. Improved structure of the QDIB-IR photodetector achieved by inserting damping, passivating and contact layers as well as a back reflector.
Figure 8. Variation of the QDIB-IR photodetector structure in which the front emitter does not cover completely the front side.
Figure 9. Variation of the QDIB-IR photodetector structure in which both contacts are placed at the rear side.
Figure 10. Layer structure of the preferred embodiment for the QDIB-IR photodetector.
Figure 11. Schematics showing the final steps of the fabrication process of a QDIB-IR photodetector.
Figure 12. Experimental current output of a QDIB-IR photodetector as a function of the incident photons flow.
Figure 13. Experimental voltage output of a QDIB-IR photodetector as a function of the infrared radiant input power.

### INDUSTRIAL APPLICATION

The QDIB-IR photodetector can be used to detect infrared radiation, both in the long-wavelength infrared region (1-30 microns) as in the far-infrared region (more than 30 microns) depending on the dot size. This capability to detect infrared light makes them suitable for manufacturing gas and molecule analyzers, flame detectors, and thermographic cameras.

In the gas an molecules analyzers, the QDIB-IR detector is used together with an infrared source and a monochromator. First, the monochromator scans the infrared source and focuses its output into the detector. The gas or dilution containing the molecules to be analyzed is inserted in-between this output and the detector. Previously, no test sample might have been inserted in order to set the reference for the measurement. By registering the output of the detector as a function of the wavelength and comparing the result with the reference, it is possible to determine at what wavelength or wavelengths infrared absorption is taking place. Since, at this respect, each molecule has got its own absorption signature, it is possible to identify the molecules present in the sample and even its concentration since the latest is a function of the intensity of the absorption. Alternatively, instead of a system conceptually based in a monochromator, techniques based on the Fourier Transform of the Infrared Radiation (FTIR) can be used.

As a flame or fire detector, the QDIB-IR would continuously monitor the subject under surveillance. When a fire starts, the phenomena is followed by a rising in the temperature and therefore, by an increase in the amount of infrared radiation that the QDIB-IR will detect. Without having an actual fire or flame, the QDIB-IR can also be used for contactless temperature measurements.

Since the QDIB-IR can detect radiation for incidence normal to the plane of growth, an array of these devices can be integrated in the same wafer to constitute the pixels of an imagining device. Furthermore, some of the photodectors in the array can be designed to detect mainly radiation at a given wavelength while others are at a different one. In this way, a multi-color array could be fabricated. Either way, the array will constitute the basic element of a thermographic camera with military (detection of targets) and medical applications (identification of harmed tissues). The use of QDIB-IR will also relax the need of detector cooling.

## Claims

1. Infrared photodetector device by means of producing an electric current or a voltage that involves:
a semiconductor *p*-type layer (4), which we call *"p-* emitter";
a semiconductor *n*-type layer (3), which we call "*n*-emitter"; between both of them, one or more quantum dot layers (11) separated among them by layers of semiconductor barrier (2);
and where the energy levels corresponding to the confined states in the dots (7) are separated by a zero density of states from the conduction (8) and valence (15) bands and contain both empty states able to receive electrons from the valence band and full states that can pump electrons to the conduction band.

2. Infrared photodetector device, according to claim 1, **characterised by** the fact that the energy levels corresponding to the electrons confined in the dots (7) originate from a confined potential in the conduction band or the valence band.

3. Infrared photodetector device, according to claims 1 to 2, in which the band structure of the dots is either of type I or type II.

4. Infrared photodetector device, according to claims 1 to 3, in which the barrier or dot regions are doped to fill the confined states with electrons or holes.

5. Infrared photodetector device, according to claim 1 to 4, in which the emitter which receives the IR-radiation in the first place is either *p*-type or *n*-type.

6. Infrared photodetector device, according to claims 1 to 5, in which the emitter that receives the radiation is covered by a metallization grid that makes the electrical contact and allows the IR-radiation to pass through towards the inner structure.

7. Infrared photodetector device, according to claims 1 to 6, in which the layers that constitute the p- and n- emitter can be substituted by *p*-type and n-type regions both at the rear side of the device.

8. Infrared photodetector device, according to claims 1 to 7, in which the semiconductor that constitutes the n or *p* emitters have a higher bandgap than the barrier material.

9. Infrared photodetector device, according to claims 1 to 8, in which an *n*-type layer can be inserted between the p emitter and the region with quantum dots and the barrier semiconductor layers.

10. Infrared photodetector device, according to claims 1 to 9, in which a *p*-type layer can be inserted between the n emitter and the region with quantum dots and the barrier semiconductor layers.

11. Infrared photodetector device, according to claims 1 to 10 **characterised by** the emitter having a surface passivating layer (43) that reduces surface recombination speed.

12. Infrared photodetector device, according to claims 1 to 11 **characterised by** an IR-radiation back reflector located at the rear side of the device, in order to reflect the non-absorbed photons towards the dot region.

13. Infrared photodetector device according to claims 1 to 12 **characterised by** a filter (12) that allows only IR-radiation to flow towards the device surface.

14. A method to covert light into electric signals, using the device described in claims 1 to 13, that consists of the following: photons from the IR- radiation to be detected pump electrons (6) from the energy levels created by the confined electrons in the dots, to the higher energy levels, being this transition assisted by electron pumping from the lower energy levels to the energy levels created by the confined electrons in the dots (34), being this last transition, at its time, caused either by a thermal mechanism or by a light source external to the device.

15. Method, according claim 14, in which photons from the IR-radiation to be detected pump electrons from the lower energy levels to energy levels created by the confined electrons in the dots, being this transition assisted by electron pumping from the energy levels created by the confined electrons in the dots to the higher energy levels, being this last transition, at its time, caused either by a thermal mechanism or by a light source external to the device.
